(19) Europäisches Patentamt

**European Patent Office**

**Office européen des brevets**

(11) Veröffentlichungsnummer: **0 207 054 B1**

(12) **EUROPÄISCHE PATENTSCHRIFT**

(45) Veröffentlichungstag der Patentschrift: **29.07.92**

(21) Anmeldenummer: **86890141.4**

(22) Anmeldetag: **14.05.86**

(51) Int. Cl.5: **H02J 7/02**, G01R 31/36

(54) **Gerät mit einer aufladbaren Batterie.**

(30) Priorität: **28.06.85 AT 1932/85**

(43) Veröffentlichungstag der Anmeldung:
**30.12.86 Patentblatt 86/52**

(45) Bekanntmachung des Hinweises auf die
Patenterteilung:
**29.07.92 Patentblatt 92/31**

(84) Benannte Vertragsstaaten:
**AT BE CH DE FR GB IT LI LU NL SE**

(56) Entgegenhaltungen:
**EP-A- 0 079 788**
**DE-A- 2 742 675**
**GB-A- 2 081 531**

(73) Patentinhaber: **Mata, Friedrich**
**Voralpenstrasse 12**
**A-3130 Herzogenburg(AT)**

(72) Erfinder: **Mata, Friedrich**
**Voralpenstrasse 12**
**A-3130 Herzogenburg(AT)**

(74) Vertreter: **Gibler, Ferdinand, Dipl.Ing. Dr.
techn.**
**Dorotheergasse 7/14**
**A-1010 Wien(AT)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein Gerät, insbesondere Lampe, mit einer vorzugsweise aufladbaren Batterie, bei dem eine Einrichtung zur Anzeige der restlichen Kapazität der Batterie mittels einer Vielzahl von Leuchtdioden, welche Einrichtung über einen Taster mit der Batterie verbindbar ist und bei der ein Komparator und eine Konstantspannungsquelle vorgesehen sind, die eine deutlich unter der Batteriespannung liegende Referenzspannung liefert, wobei jede Leuchtdiode mit dem Ausgang eines ihr zugeordneten Komparators verbunden ist und deren zweite Elektroden miteinander verbunden sind.

Ein solches Gerät wurde z.B. durch die EU-A1 79 788 bekannt. Bei diesem bekannten Gerät ist ein digitaler Kreis mit einem digitalen Integrator vorgesehen, der numerische Werte in binärer digitaler Form speichert und der den Ladungszustand der Batterie anzeigt. Dieser digitale Integrator ändert seinen numerischen Wert in Abhängigkeit von der erfaßten Abnahme der Ladung der Batterie. Weiters ist bei diesem bekannten Gerät eine Lastabwurfschaltung vorgesehen, die bei Unterschreiten einer bestimmten Batteriespannung die Last wegschaltet, bzw. reduziert.

Der Nachteil dieser Lösung liegt in dem relativ hohen schaltungstechnischen Aufwand. Außerdem läßt sich die bekannte Schaltung zur Überwachung des Ladungszustandes der Batterie nur schwer an die jeweiligen Verhältnisse anpassen, wenn hochintegrierte Bauteile verwendet werden.

Weiters wurde durch die DE-A-2 742 675 eine Einrichtung der eingangs erwähnten Art bekannt, bei der die Spannung der Batterie mittels eines Analog-Digitalwandlers überwacht wird, der eine Reihe von Leuchtdioden steuert, die den Ladungszustand der Batterie anzeigen.

Auch bei dieser Lösung ergibt sich der Nachteil eines hohen schaltungstechnischen Aufwandes, wobei die einzelnen angezeigten Stufen der Ladung der Batterie durch die Auslegung des Analog-Digitalwandlers festgelegt sind. Da solche Bauteile meist als hochintegrierte Bauteile ausgebildet sind, ergeben sich entsprechende Probleme bei der Anpassung der Schaltung an die jeweiligen Verhältnisse.

Weiters wurde durch die GB-A-2 081 531 eine Handlampe bekannt, bei der ein Pufferbetrieb möglich ist und bei der zur Anzeige des Ladungszustandes der Batterie Serienschaltungen von Widerständen und Leuchtdioden parallel zur Batterie geschaltet sind, wobei die Widerstände unterschiedliche Werte aufweisen.

Bei dieser sehr einfachen überwachungsschaltung zur Kontrolle des Ladungszustandes der Batterie ergibt sich aufgrund der meist beträchtlichen Bauteiltoleranzen nur eine bescheidene Genauigkeit der Anzeige.

Ziel der Erfindung ist es diese Nachteile zu vermeiden und ein Gerät der eingangs erwähnten Art vorzuschlagen, das sich leicht an die jeweiligen Gegebenheiten anpassen läßt und sich durch eine relativ hohe Genauigkeit der Anzeige auszeichnet.

Erfindungsgemäß wird dies dadurch erreicht, daß die Komparatoren mit ihren einen Eingängen an einem von der Batterie bestimmten Potential liegen und deren andere Eingänge mit unterschiedlichen Referenzspannungen beaufschlagt sind, daß die Konstantspannungsquelle an eine Reihenschaltung von Widerständen angeschlossen ist, an denen die Referenzspannungen (Sollspannungen), die nach der Kennlinie der verwendeten Batterie ausgewählt sind, wobei an den Verbindungspunkten der Widerstände die Referenzeingänge der Komparatoren angeschlossen sind und die Vergleichsspannungen (Istspannungen) als gemeinsames Potential von einem mit der Batterie verbindbaren Spannungsteiler abgegriffen und den anderen Eingängen der Komparatoren zuführbar sind.

Auf diese Weise läßt sich mit relativ einfachen Mitteln eine relativ präzise Anzeige erreichen, wobei sich durch die Wahl entsprechender Referenzspannungen eine einfache Anpassung an die jeweiligen Erfordernisse ergibt. Außerdem ergibt sich ein sehr einfacher Schaltungsaufbau.

Bei einem erfindungsgemäßen Gerät mit einer Lastabwurfschaltung, die beim Absinken der Batteriespannung unter einem vorgegebenen Wert zumindest einen Teil der Last wegschaltet, kann nach einem weiteren Merkmal der Erfindung vorgesehen sein, daß die Lastabwurfschaltung durch einen an die Konstantspannungsquelle über eine Spannungsteilerschaltung mit einem Eingang angeschlossenen Komparator gebildet ist, deren zweiter Eingang mit einem durch die Batterie bestimmten Potential verbunden ist und der bei Absinken der Batteriespannung auf einen bestimmten Wert einen in Serie zur Lampe liegenden Schalter vorzugsweise über eine Logikschaltung sperrt und einen in Serie zu einer parallel zur Lampe geschalteten Notlampe mit geringem Stromverbrauch liegenden Schalter durchschaltet.

Auf diese Weise ergibt sich eine einfache Ausbildung der Lastabwurfschaltung, die es ermöglicht, im Falle eines sehr erheblichen Absinkens der Batteriekapazität einen Notbetrieb aufrecht zu erhalten.

In diesem Zusammenhang kann weiters vorgesehen sein, daß an den Verbindungspunkt der Lampe mit dem Schalter ein Fadenbruch-Detektor angeschlossen ist, der bei einem Fadenbruch der Lampe den der Notlampe zugeordneten Schalter durchschaltet und den der Lampe zugeordneten Schalter sperrt und gegebenenfalls ein oszillierendes Signal an die Einrichtung zur Anzeige der Restkapazität legt. Damit ist sichergestellt, daß auch bei Ausfall der Lampe ein Notlicht zur Verfügung steht. Außerdem kann bei einer Kontrolle der restlichen Kapazität der Batterie eine schadhafte Hauptlampe erkannt werden, ohne daß diese selbst in Betrieb genommen werden muß. Dabei kann auch vorgesehen sein, daß an den Verbindungspunkt der Notlampe mit dem ihr zugeordneten Schalter ein Fadenbruch-Detektor angeschlossen ist, der bei einem Fadenbruch ein oszillierendes Signal an die Einrichtung zur Anzeige der Restkapazität legt, wodurch auf einfache Weise auch eine schadhafte Notlampe erkannt werden kann, wenn die Restkapazität der Batterie überprüft wird.

Bei einer bevorzugten Ausführungsform der Erfindung kann vorgesehen sein, daß der an die Lampe angeschlossene Fadenbruch-Detektor durch einen Komparator gebildet ist, dessen einer Eingang mit der Lampe und über einen Widerstand mit einem im wesentlich festen und vorn an der Lampe liegenden Potential verschiedenen Potential verbunden ist und dessen anderer Eingang mit einem von der Batterie abgeleiteten vom Anschlußpotential des mit dem ersten Eingang verbundenen Widerstandes gegen das an der Lampe liegende Potential zu abweichenden Potential verbunden ist und dessen Ausgang mit der die die den beiden Lampen zugeordneten Schaltern steuernden Logik und gegebenfalls einer mit der Anzeige der restlichen Kapazität der Batterie verbundenen Blinkschaltung verbunden ist, wobei der Komparator vorzugweise lediglich zu einem festen Potential durchschaltet oder dieses trennt. Auf diese Weise ergibt sich ein sehr einfacher Aufbau eines Fadenbruch-Detektors der gleichzeitig auch für eine automatische Umschaltung auf die Notlampe sorgt.

Weiters kann auch vorgesehen sein, daß der an die Notlampe angeschlossene Fadenbruch-Detektor durch einen Komparator gebildet ist, dessen einer Eingang mit der Notlampe und über einen Widerstand mit einem im wesentlichen festen und von dem an der Notlampe liegenden Potential verschiedenen Potential verbunden ist und dessen anderer Eingang mit einem von der Batterie abgeleiteten vom Anschlußpotential des mit dem ersten Eingang verbundenen Widerstandes gegen das an der Notlampe liegende Potential abweichenden Potential verbunden und dessen Ausgang mit einer mit der Anzeige der restlichen Kapazität der Batterie verbundenen Blinkschaltung verbunden ist, die vorzugsweise durch eine Oszillatorschaltung an der ein an seinem Ausgang lediglich ein festes Potential durchschaltender oder dieses trennender Komparator mit seinem einen Eingang über einen Spannungsteiler angeschlossen ist, dessen zweiter Eingang mit über einen mit einem festen Potential und dem Ausgang des Komparators des Fadenbruch-Detektors der Notlampe verbundenen Spannungsteiler verbunden ist, und dessen Ausgang mit den miteinander verbundenen Eingängen der Komparatoren der Einrichtung zur Anzeige der restlichen Kapazität der Batterie verbunden ist, gebildet ist, wodurch sich auch im Falle des Fadenbruch-Detektors der Notlampe ein sehr einfacher Schaltungsaufbau ergibt.

Um die aufladbare Batterie vor einer Beschädigung zu schützen, kann nach einem weiteren Merkmal der Erfindung vorgesehen sein, daß ein Komparator vorgesehen ist, dessen einer Eingang über einen Spannungsteiler an die Batterie angeschlossen ist und dessen Referenzeingang uber einen Spannungsteiler an ein über einen Spannungsstabilisator von der Batterie abgeleitetes Potential gelegt ist und dessen Ausgang mit der die den beiden Lampen zugeordneten Schaltern steuernden Logik verbunden ist.

Dabei kann der an den Referenzeingang angeschlossene Spannungsteiler die Grenze für die tiefste Entladung der Batterie festlegen. Bei Erreichen dieser Grenze werden dann die den beiden Lampen zugeordneten Schalter gesperrt, um eine zu tiefe Entladung der Batterie zu vermeiden.

Bei einer bevorzugten Ausführungsform kann weiters vorgesehen sein,daß eine Ladenbegrenzungsschaltung vorgesehen ist, die durch einen Komparator gebildet ist dessen Referenzeingang an einen über einen Spannungsregler von einer ungeregelten Gleichspannungsquelle versorgten Spannungsteiler und dessen anderer Eingang über einen Spannungsteiler mit der Batterie verbunden ist und dessen Ausgangssignal eine Ladestrom-Regelschaltung freigibt oder sperrt, wodurch eine Überladung verhindert wird. Um dabei ein ständiges Pendeln der Begrenzungsschaltung zu vermeiden ist es vorteilhaft, wenn der Ausgang des Komparators über einen Widerstand und einen Schalter, vorzugsweise eine Diode mit seinem Referenzeingang verbunden ist.

Weiters kann vorgesehen sein, daß ein Schalter vorgesehen ist, der in einer Stellung einen Pufferbetrieb ermöglicht um einen stationären Betrieb bei Schonung der Kapazität der Batterie bzw. ein gleichzeitiges Aufladen derselben zu ermöglichen.

Die Erfindung wird nun an Hand der Zeichnung näher erläutert, die ein erfindungsgemäßes Gerät zeigt. Dabei zeigt :
Fig.1 die Ladelogik des Gerätes und
Fig.2a bis 2c die gesamte Schaltung des Gerätes.

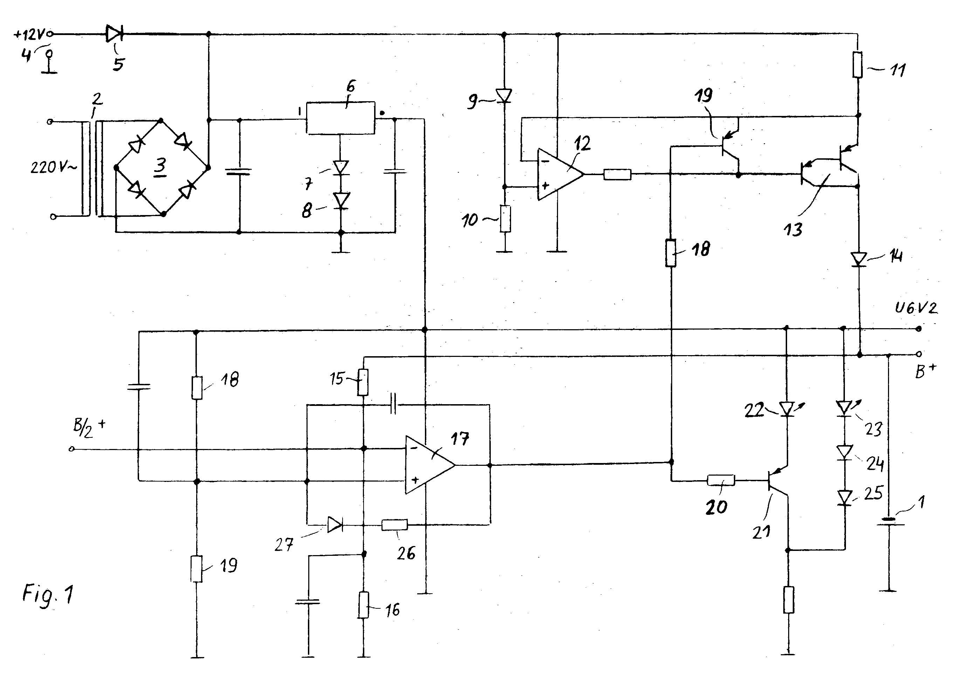

Vorerst wird Bezug auf die Fig.1 genommen ,die die Schaltung der Ladelogik zeigt. Die Batterie 1 ist entwder über eine 200 V Wechselspannungsquelle und eine durch den Transformator 2 und die Gleichrichterbrücke 3 gebildete Gleichrichterschaltung,oder über eine externe Gleichspannungsversorgung (z.B. Autobatterie) 4, aufladbar, wobei eine Entkopplungsdiode 5 vorgesehen ist, die eine Einspeisung von der Gleichrichter - brücke 3 in die Gleichspannungsquelle 4 verhindert, wenn fälschlicherweise sowohl die 220V Wechselspannungsquelle, als auch die externe Gleichspannungsquelle angeschlossen sind. Die ungeregelten Gleichspannungsquellen 2,3 bzw. 4 sind mit einem Spannungsregler 6 verbunden der z.B. eine stabilisierte Spannung von 5V liefert. Durch die an diesen angeschlossenen Dioden 7,8 wird diese auf ca. 6,2V gerhöht, welche Spannung zu der Klemme U6V2 geführt ist.

Weiters sind an den ungeregelten Gleichspannungsquellen noch eine aus der Referenzdiode 9 und einem Widerstand 10 bestehende Serienschaltung und einen zur Erfassung des Ladestromes dienenden Widerstand 11 angeschlossen, wobei die Referenzdiode 9 mit dem Referenzeingang eines Differenzverstärkers 12 verbunden ist, dessen zweiter Eingang mit dem Widerstand 11 verbunden ist, der den Istwert des Ladestromes liefert. Der Ausgang des Differenzverstärkers 12 steuert den in Serie zum Widerstand 11 geschalteten Darlington-Transistor 13, der über eine Diode 14 mit der Batterie 1 bzw. der Klemme B verbunden ist.

An diese Klemme B ist ein Spannungsteiler 15,16 mit gleich großen Widerständen angeschlossen, an dessen Mittelanzapfung eine Klemme B/2 und ein Eingang eines Komparators 17 angeschlossen sind, desen Referenzeingang an einen, an die Klemme U6V2 bzw. stabilisierte Spannung angeschlossenen Spannungsteiler 18,19 angeschlossen ist.

Steigt die Batteriespannung über einen durch die am Referenzeingang + des Komparators 17 liegende Referenzspannung bestimmten Wert an, so ändert sich dessen Ausganssignal auf "LOW" bzw. der Komparator 17 schaltet auf Masse durch. Dadurch kann über den Widerstand 18 der Basisstrom des Transistors 19 fließen, der die Emitter-Basisstrecke des Darlington-Transistors 13 in diesem Fall kurzschließt und dadurch diesen sperrt, sodaß kein Ladestrom mehr fließen kann.

Gleichzeitig kann über den Widerstand 20 der Basisstrom des Transistors 21 fließen, sodaß dieser durchschaltet und Strom über die grüne Leuchtdiode 22 fließen kann, sodaß diese leuchtet und das Ende des Ladevorganges anzeigt. Dies bewirkt gleichzeitig ein Anheben des Potentials am Kollektor des Transistors 21 da über die Leuchtdiode 22 und den Transistor 21 nur ca. 2V abfallen, in dem durch die rote Leuchtdiode 23 und die beiden Dioden 24,25 gebildeten parallel geschalteten Serienkreis aber ca. 3V abfallen müssen um diese Dioden durchschalten zu können, sodaß der Stromfluß über diese Reihenschaltung unterbrochen wird und die den Ladevorgang anzeigende rote Leuchtdiode 23 erlischt.

Um eine entsprechende Schalthysterese des Komparators 17 sicherzustellen, ist dessen Ausgang über den Widerstand 26 und die als Schalter wirkende Diode 27 an dessen Referenzeingang rückgekoppelt.Dadurch kommt es, sobald der Ausgang des Komparators 17 auf Masse durchschaltet zu einem Stromfluß über die Diode 27 und damit zu einer Parallelschaltung der Widerstände 19 und 26, wodurch die Referenzspannung am Eingang + des Komparators 17 absinkt und dieser erst bei Unterschreitung eines bestimmten Spannungswertes der Batterie wieder auf "HIGH" an seinem Ausgang schaltet und damit den Transistor 19 und den Transistor 21 wieder sperrt. Damit ist der Darlingtontransistor 13 wieder freigegeben und es kann ein Ladestrom fließen. Gleichzeitig erlischt die gründe Leuchtdiode 22 und die rote Leuchtdiode leuchtet auf und zeigt an, daß die Batterie wieder geladen wird.

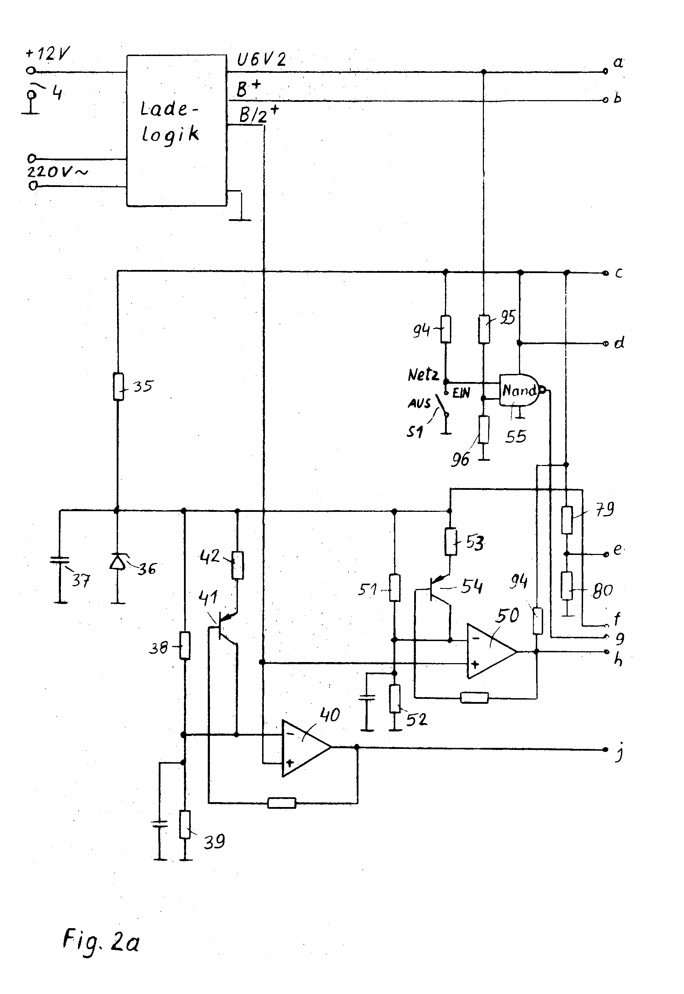

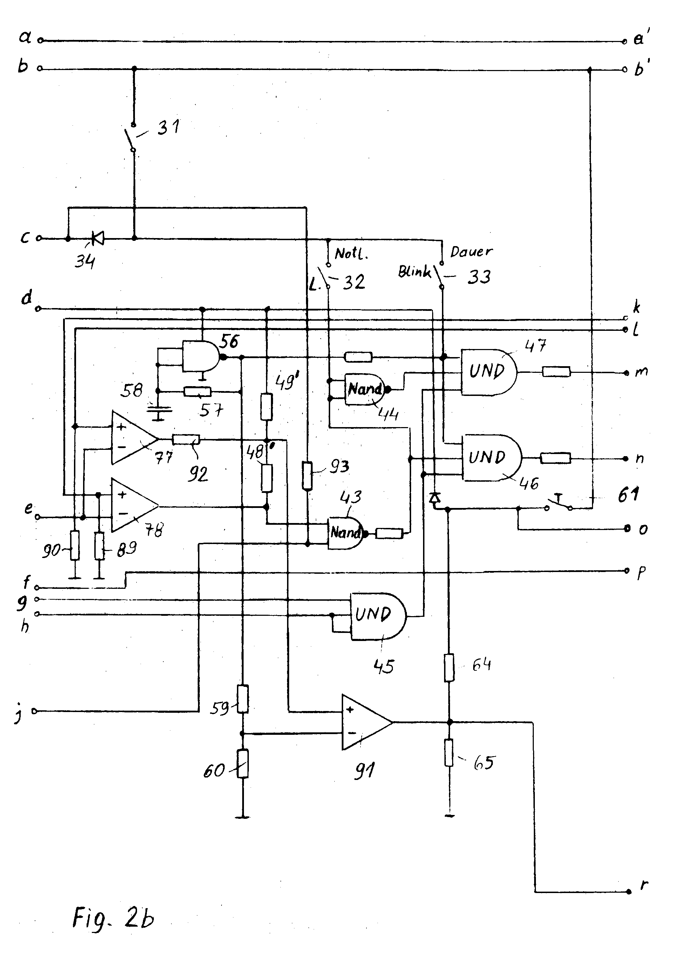

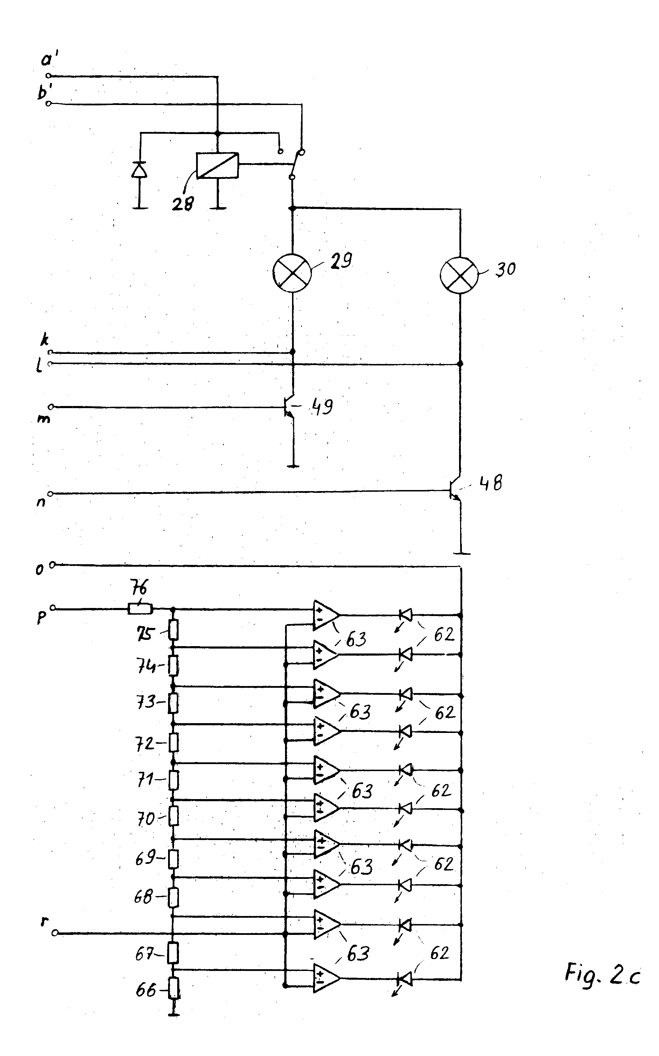

Die Fig.2, die die Gesamtschaltung des erfindungsgemäßen Gerätes zeigt, wurde der besseren Übersichtlichkeit wegen in drei Teile geteilt,wobei die zusammengehörigen Anschlußstellen mit Kleinbuchstaben a-r bezeichnet sind.

Wird das Gerät vom Netz bzw. der externen 12V-Gleichspannungsversorgung 4 getrennt, so liegt auch an der Klemme U6V2 der Ladelogik über den Spannungsteiler 18,19 Masse und das Relais 28 fällt ab, sodaß eine Spannungsversorgung der Lampe 29 und der dazu parallel geschalteten Notlampe 30, die eine geringere Leistungsaufnahme aufweist als die Lampe 29 über die Batterie erfolgt. Bei vorhandener Netzversorgung, wobei die Klemme U6V2 an Spannung liegt, ist das Relais 28 erregt und die Lampen 29,30 werden über die Klemme U6V2 versorgt (Fig.2c),(d.h. der Lichtstrom wird der externen Spannungsversorgung und nicht der Batterie entnommen).

Um die Lampe 29 in Betrieb zu nehmen, genügt es den Schalter 31 (Fig.2b) zu schließen und mit den Schaltern 32, und 33 die gewünschte Betriebsart zu wählen und zwar kann mit dem Schalter 32 die Lampe 29 oder die Notlampe 30 gewählt und mit dem Schalter 33 Dauerlicht oder Blinklicht gewählt werden (Fig.2b). An den Schalter 31 ist über eine Diode 34 und einen Widerstand 35 eine aus einer Zenerdiode 36 und einen Kondensator 37 bestehende Spannungsstabilisierungsschaltung angeschlossen. An diese ist ein Spannungsteiler 38,39 angeschlossen, an den der Referenzeingang eines Komparators 40 angeschlossen ist, dessen zweiter Eingang mit der Klemme B/2 + verbunden ist, wobei die durch den Spannungsteiler 38,39 bestimmte Referenzspannung so gewählt ist, daß der Ausgang des Komparators 40 auf Masse durchschaltet, wenn die Batterie 1 bereits weitgehend entladen ist. In diesem Fall kommt es über den Transistor 41, dessen Basis mit dem Ausgang des Komparators 40 verbunden ist zu einer Parallelschaltung des Widerstandes 42 zum Widerstand 38, wodurch sich die am Komparator angelegte Referenzspannung erhöht und dadurch ein Pendeln des Komparators zwischen seinen beiden Ausgangszuständen im Falle einer Entlastung der Batterie,die mit dem Durchschalten des Komparators 40 auf Masse verbunden ist, vermieden wird.

Das Ausgangssignal des Komparators 40, das bei genügender Ladung der Batterie 1 ein "HIGH" Signal ist, wird an die aus den Gattern 43,44, 45,46,47 bestehende Logik und zwar an das NAND-Gatter 43, dessen zweiter Eingang über den Spannungsteiler 48',49' an die Diode 34 angeschlossen ist und daher bei geschlossenem Schalter 31 mit einem "HIGH"-Signal beaufschlagt ist. Dadurch ist das den der Notlampe 30 zugeordneten Transistor 48 steuernde UND-Gatter 46 gesperrt, solange der Schalter 32 geöffnet ist und der Komparator 40 ein "HIGH"-Signal liefert.

An dem den der Lampe 29 zugeordneten UND-Gatter liegt unter den gleichen Bedingungen dagegen ein vom NAND-Gatter 44, das praktisch nur als Inverter geschaltet ist, kommendes Freigabesignal an, sodaß falls noch andere Bedingungen erfüllt sind, dieses Gatter den der Lampe 29 zugeordneten Transistor 49 durchschalten kann.

Bei weitgehender Entladung der Batterie schaltet der Ausgang des Komparators 40 auf "LOW", wodurch über das NAND-Gatter 43, das UND-Gatter 46 freigegeben wird und über den Transistor 48 die Notlampe einschaltet. Gleichzeitig wird über das NAND-Gatter 44 das UND-Gatter 47 gesperrt, das wiederum den Transistor 49 sperrt und somit die Hauptlampe abgeschaltet wird. Dadurch wird erreicht, daß die Batterie weniger belastet wird, und trotzdem noch Licht für den Rückweg zur Ladestelle (ca. noch 1 Stunde) vorhanden ist.

Eine dieser Bedingungen ist, daß der Ausgang des Komparators 50 (Fig.2a), der zum Schutz gegen eine zu tiefe Entladung der Batterie vorgesehen ist, und der ähnlich wie der Komparator 40 mit seinem Referenzeingang an einen an die Spannungsstabilisierschaltung 36,37 angeschlossenen Spannungsteiler und mit seinem zweiten Eingang an die Klemme B/2+ angeschlossen ist, nicht auf Masse durchgeschaltet ist. Diese Durchschaltung erfolgt, wenn die Batterie gefährlich weit entladen ist. Auch bei diesem Komparator ist zur Erzielung einer entsprechenden Schalthysterese eine Prallelschaltung eines Widerstandes 53 über einen Transistor 54 zum Widerstand 51 des Spannungsteilers 51,52 vorgesehen, wenn der Ausgang des Komparators 50 auf Masse durchschaltet. In diesem Fall gibt das UND-Gatter 45, dessen zweiter Eingang über das NAND-Gatter 55 mit einem "HIGH"-Signal versorgt ist wenn keine Netzversorgung vorhanden ist und daher die Klemme U6V2 spannungslos ist, oder bei vorhandener Netzversorgung der Schalter S1 in Stellung "EIN" gebracht ist, kein "HIGH"-Signal an die UND-Gatter 46,47 ab, sodaß diese die zugeordneten Transistoren 48,49 nicht durchschalten können und daher auch die Lampen 29,30 nicht in Betrieb genommen werden können. Dadurch wird erreicht, daß bei leerer Batterie die gesamte Last von der Batterie geschaltet wird und dadurch eine Tiefentladung der Batterie verhindert wird.

Im Normalfall, d.h. bei genügend geladener Batterie und keiner Netzversorgung oder Netzversorgung mit Schalter S1 in Stellung "EIN" gibt das UND-Gatter 45 ein "HIGH"-Signal an die Gatter 46 und 47 ab und bereitet diese auf eine Durchschaltung vor.Ein Dauerbetrieb der Handlampe wird somit sichergestellt, bei gleichzeitiger Ladung der Batterie. Ist der Schalter S1 in Stellung "AUS", ist der Ausgang des NAND-Gatters 55 abhängig von der Spannung U6V2. Ist eine der externen Spannungsversorgungen ausgeschlossen, liefert der Ausgang des NAND-Gatters 55 ein "LOW"-Signal und sperrt damit über das UND-Gatter 45 die UND-Gatter 46,47 wodurch die Lampen 29,30 abgeshaltet werden. Erst bei Ausfall der externen Spannungsquelle schaltet das NAND-Gatter 55 auf "HIGH" und die über Schalter 31,32 und 33 eingestellte Funktion wird freigegeben. Dadurch bewirkt, daß z.B. bei Netzausfall die Lichtversorgung vom Handscheinwerfer übernommen wird.

Die einen Eingänge der beiden UND-Gatter 46,47 sind mit dem Schalter 33, mit dem in Stellung "Dauer" ein Dauersignal anlegbar ist, und mit einer Oszillatorschaltung , die durch das NAND-Gatter 56, das eine größere Schalthysterese aufweist und den Widerstand 57 sowie den Kondensator 58 gebildet ist, verbunden. Das Oszillatorsignal ist sofort vorhanden, wenn Schalter 31 bzw. T61 betätigt werden. Der Kondensator ist im Einschaltzustand entladen. Der Ausgang des NAND-Gatters 56 ist somit "HIGH" und beginnt den Kondensator 58 über den Widerstand 57 aufzuladen. Wird die Kippschwelle "Ein" des Gatters 56 erreicht, schaltet der Ausgang dieses Gatters auf "LOW" und der Kondensator 58 wird über Widerstand 57 wieder entladen. Wird die Kippschwelle "AUS" des Gatters erreicht, kippt der Ausgang des Gatters 56 wieder auf "HIG" usw. Die Frequenz ist proportional dem Produkt des Widerstandwertes Kondensatorkapazität.Ist der Schalter 33 offen, liegt das Oszillatorsignal an den Eingängen der UND -Gatter 46,47 an. Je nachdem, welches der beiden UND-Gatter freigegeben ist, wird das Oszillatorsignal dem Transistor 48 bzw. 49 zugeführt, das zu einem Blinken der betreffenden Lampe führt.

Zur Anzeige der restlichen Kapazität der Batterie 1 ist ein Taster 61 an die Batterie 1 bzw. die Klemme B+ angeschlossen.Über diesen Taster 61 sind die einen Elektroden einer Anzahl von parallel geschalteten Leuchtdioden 62, deren andere Elektroden mit dem Ausgang je eines zugeordneten Komparators 63 verbunden sind, an die Klemme B+ anschließbar.

Über den Taster 61 ist auch ein Spannungsteiler 64,65 mit der Klemme B+ verbindbar,dessen Mittelanzapfung mit den einen, miteinander verbundenen Eingängen der Komparatoren 63, verbunden ist.

Die Referenzeingänge + der Komparatoren 63 sind an Abgriffe einer Serienschaltung von Widerständen 66 bis 76 gelegt, die zweckmäßigerweise gemäß der Kennlinie der Batterie 1 derart ausgelegt sind, daß die Anzahl der leuchtenden Leuchtdioden 62 der Anzahl der noch verbleibenden Betriebsstunden der Lampe 29 bis zur nächsten Aufladung der Batterie entsprechen, wobei die Komparatoren 63 an ihren Ausgängen dann auf Masse durchschalten, wenn die an ihren Referenzeingängen + anliegende Spannung negativer als die an ihren anderen Eingängen anliegende Spannung ist. Zwischen den Lampen 29,30 und ihren zugeordneten Transistoren sind Fadenbruch-Detektoren angeschlossen, die im wesentlichen durch die Komparatoren 77,78 gebildet sind.

Die Referenzeingänge (-) dieser Komparatoren 77,78 sind über den Spannungsteiler 79,80 (Fig.2a) und den Schalter 31 an die Klemme B+ anschließbar, bzw. mit der Batterie verbindbar, wobei dieser Spannungsteiler so dimensioniert ist, daß das an den Referenzeingängen liegende Potential nur relativ wenig über dem Massenpotential liegt, jedoch unterhalb von UcEsat liegt. Die anderen Eingänge dieser Komparatoren 78,77 sind mit der Lampe 29 und einem an Masse liegenden Widerstand 89 bzw. mit der Lampe 30 und einem an Masse liegenden Widerstand 90 verbunden. Da bei intaktem Faden einer jeden Lampe und offenem Schalter 31 stets die volle Batteriespannung oder bei vorhandener Netzversorgung die geregelte Spannung U5V2 an den Lampen 29,30 über den Kontakt des Relais 28 ansteht, steht diese Spannung, da die Transistoren 49,48 wegen des offenen Schalters 31 gesperrt sind, auch an den +Eingängen der Komparatoren 77,78 an, sodaß deren Ausgänge zu keinem Potential durchgeschaltet sind und das durch die äußere Beschaltung des Ausganges bestimmte Potential annehmen.Bei geschlossenem Schalter 31 liegt an dem +Eingang eines jeden der Komparatoren aufgrund der Emitter-Kollektorspannung des entsprechenden Transistors 49,50 noch ein über dem Referenzpotential liegendes Potential an, sodaß es auch beim Einschalten einer Lampe zu keinem Kippen eines der Komparatoren 77,78 kommt. Liegt jedoch ein Bruch eines Fadens einer Lampe vor, so wird der +Eingang des zugeordneten Komparators 77 oder 78 über den Widerstand 90 bzw. 89 auf Massepotential gezogen, sodaß dieser Komparator aufgrund des höheren Referenzpotentials seiner Ausgänge auf Masse durchschaltet. Im Falle des Komparators 78,der die Lampe 29 überwacht führt dies dazu, daß der eine Eingang des NAND-Gatters 43 statt eines "HIGH"-Signals über den Spannungsteiler 49,48 ein "LOW"-Signal erhält und an seinem Ausgang ein "HIGH"-Signal abgibt, wodurch über das NAND-Gatter 44 das UND-Gatter 47 gesperrt wird und dadurch auch der Transistor 49 gesperrt wird. Gleichzeitig wird durch das "HIGH" -Signal des NAND-Gatters 43 das UND-Gatter 46 durchgeschaltet, wodurch auch der Transistor 48 durchgeschaltet wird, sodaß im Falle eines Bruchs des Fadens bei in Betrieb genommener Lampe 29 eine automatische Umschaltung auf die Notlampe 30 erfolgt.

Gleichzeitig wird durch die Durchschaltung des Ausgangs des Komparators 78 auf Masse über den Spannungsteiler 49',48' auch das Potential des +Einganges des Komparators 91 geändert,dessen Referenzeingang über den Spannungsteiler 59,60 mit der Oszillatorschaltung 56,57,58 verbunden ist, wobei das bei auf Masse durchgeschaltetem Ausgang des Komparators 78 am +Eingang des Komparators 91 liegende Potential negativer ist als dessen Referenzpotential während einer "HIGH"-Signal Periode der Oszillatorschaltung, sodaß der Komparator 91 oszillierend auf Masse durchschaltet und dadurch das Referenzpotential der Komparatoren 63, welche die Leuchtdiode 62 der Kapazitätsanzeige steuern, abwechselnd wegschaltet. Dadurch kommt es bei gedrückter Taste 61 zu einem Blinken der Leuchtdioden 62,wodurch der Bruch eines Fadens einer Lampe 29,30 angezeigt wird,ohne daß versucht werden muß, diese in Betrieb zu nehmen.

Der Komparator 77, der die Notlampe 30 überwacht arbeitet in gleicher Weise wie der Komparator 78, doch beeinflußt sein Ausgang nur den Spannungsteiler 49', 92 wodurch es ebenfalls zu einem Blinken der Leuchtdioden 62 in der oben beschriebenen Weise kommt, wenn der Faden dieser Lampe gebrochen ist und deshalb der Ausgang des Komparators 77 auf Masse durchschaltet.

Um in diesem Falle ein zu weites Absinken des Potentials an dem mit dem Spannungsteiler 49',48' verbundenen Eingang des NAND-Gatters 43, was in einem solchen Fall zum unerwünschten Abschalten der Lampe 29 und einem unwirksamen Durchschalten des Transistors 48 führen würde, ist ein Widerstand 92 vorgesehen, durch den es bloß zu einer genügend weiten Potentialverschiebung am +Eingang des Komparators 91 kommt, um ein Pendeln seines Ausganges zwischen Masse und freiem Potential zu ermöglichen, aber an dem Eingang des NAND-Gatters 43 noch ein genügend hohes Potential ansteht um als "HIGH"-Signal erkannt zu werden.

Der mit dem Komparator 40 verbundene Eingang des NAND-Gatters 43 wird über den über den Schalter 31 mit der Batterie verbindbaren Widerstand 93 auf "HIGH"-Potential gehalten, solange nicht der Ausgang des Komparators 40 auf Masse durchgeschaltet hat.Gleiches gilt auch bezüglich des UND-Gatters 45, dessen mit dem Komparator 50 verbundender Eingang über den Widerstand 94, der über den Schalter 31 mit der Batterie 1, bzw. der Klemme B+ verbindbar ist, auf High-Potential gehalten wird, solange nicht der Ausgang des Komparators 50 bei bereits erschöpfter Batterie auf Masse durchschaltet. Dadurch können auch für die Komparatoren 40,50 solche verwendet werden, die lediglich gegen ein Potential durchschalten bzw. in ihrem anderen Schaltzustand sich das Potential an dessen Ausgang nach der äußeren Beschaltung einstellt. Das NAND-Gatter 55 ist mit seinem einen Eingang an über einen Widerstand 94 und den Schalter 31 mit der Batterie verbindbar und außerdem über den Schalter S1 mit Masse verbindbar. Der zweite Eingang dieses Gatters 55 ist über den Spannungsteiler 95,96 mit der Klemme U6V2 verbunden. Im Falle des Vorhandenseins einer Netzversorgung, wodurch an der Klemme U6V2 ein High-Potential ansteht, gibt das NAND-Gatter 55 bei in seiner AUS-Stellung befindlichem Schalter S1 ein "LOW"-Signal ab durch das das UND-Gatter 45 gesperrt wird, wodurch auch die UND-GAtter 46 und 47 und damit die Transistoren 48 und 49 gesperrt werden. Fällt die Netzversorgung aus oder wird der Schalter S1 in seine EIN-Stellung gebracht, so gibt das NAND-Gatter 55 ein "HIGH"-Signal ab, durch das das UND-Gatter 45 freigeschaltet wird. Damit wird es möglich,die Lampen 29 oder 30 auch bei vorhandener Netzversorgung in Betrieb zu nehmen, wobei gleichzeitig die Batterie geladen werden kann.

**Patentansprüche**

1. Gerät, insbesondere Lampe, mit einer vorzugsweise aufladbaren Batterie (1), bei dem eine Einrichtung (62, 63) zur Anzeige der restlichen Kapazität der Batterie mittels einer Vielzahl von Leuchtdioden, welche Einrichtung über einen Taster (61) mit der Batterie verbindbar ist und bei der ein Komparator und eine Konstantspannungsquelle (36, 37) vorgesehen sind, die eine deutlich unter der Batteriespannung liegende Referenzspannung liefert, wobei jede Leuchtdiode (62) mit dem Ausgang eines ihr zugeordneten Komparators (63) verbunden ist und deren zweite Elektroden miteinander verbunden sind, dadurch gekennzeichnet, daß die Komparatoren (63) mit ihren einen Eingängen an einem von der Batterie (1) bestimmten Potential liegen und deren andere Eingänge mit unterschiedlichen Referenzspannungen beaufschlagt sind, daß die Konstantspannungsquelle (36, 37) an eine Reihenschaltung von Widerständen (66 bis 76) angeschlossen ist, an denen die Referenzspannungen (Sollspannungen), die nach der Kennlinie der verwendeten Batterie (1) ausgewählt sind, wobei an den Verbindungspunkten der Widerstände (66 bis 76) die Referenzeingänge der Komparatoren (63) angeschlossen sind und die Vergleichsspannungen (Istspannungen) als gemeinsames Potential von einem mit der Batterie (1) verbindbaren Spannungsteiler (64, 65) abgegriffen und den anderen Eingängen der Komparatoren (63) zuführbar sind.

2. Gerät nach Anspruch 1 mit einer Lastabwurfschaltung, die beim Absinken der Batteriespannung unter einem vorgegebenen Wert zumindest einen Teil der Last wegschaltet, dadurch gekennzeichnet, daß die Lastabwurfschaltung durch einen an die Konstantspannungsquelle (36, 37) über eine Spannungsteilerschaltung (38, 39) mit einem Eingang angeschlossenen Komparator (40) gebildet ist, deren zweiter Eingang mit einem durch die Batterie (1) bestimmten Potential (B/2+) verbunden ist und der bei Absinken der Batteriespannung auf einen bestimmten Wert einen in Serie zur Lampe (29) liegenden Schalter (49) vorzugsweise über eine Logikschaltung (43, 44, 45, 46, 47) sperrt und einen in Serie zu einer parallel zur Lampe (29) geschalteten Notlampe (30) mit geringem Stromverbrauch liegenden Schalter (48) durchschaltet.

3. Gerät nach Anspruch 1 oder 2, dadurch gekennzeichnet, daß an den Verbindungspunkt der Lampe (29) mit dem Schalter (49) ein Fadenbruch-Detektor (78, 89) angeschlossen ist, der bei einem Fadenbruch der Lampe (29) den der Notlampe zugeordneten Schalter (48) durchschaltet und den der Lampe (29) zugeordneten Schalter (49) sperrt und gegebenenfalls ein oszillierendes Signal an die Einrichtung (62, 63) zur Anzeige der Restkapazität legt.

4. Gerät nach Anspruch 2 oder 3, dadurch gekennzeichnet, daß an den Verbindungspunkt der Notlampe (30) mit dem ihr zugeordneten Schalter (48) ein Fadenbruch-Detektor (77, 90) angeschlossen ist, der bei einem Fadenbruch ein oszillierendes Signal an die Einrichtung (62, 63) zur Anzeige der Restkapazität legt.

5. Gerät nach Anspruch 4, dadurch gekennzeichnet, daß der an die Lampe (29) angeschlossene Fadenbruch-Detektor durch einen Komparator (78) gebildet ist, dessen einer Eingang mit der Lampe (29) und über einen Widerstand (89) mit einem im wesentlichen festen und vom an der Lampe (29) liegenden Potential verschiedenen Potential verbunden ist und dessen anderer Eingang mit einem von der Batterie (1) abgeleiteten vom Anschlußpotential des mit dem ersten Eingang verbundenen Widerstandes (89) gegen das an der Lampe (29) liegende Potential zu abweichenden Potential verbunden ist und dessen Ausgang mit der die den Lampen zugeordneten Schaltern (48, 49) steuernden Logik (43, bis 47) und gegebenenfalls einer mit der Anzeige (62) der restlichen Kapazität der Batterie (1) verbundenen Blinkschaltung (56, 60, 91) verbunden ist, wobei der Komparator (78) vorzugsweise lediglich zu einem festen Potential durchschaltet oder dieses trennt.

6. Gerät nach Anspruch 5, dadurch gekennzeichnet, daß der an die Notlampe (30) angeschlossene Fadenbruch-Detektor durch einen Komparator (77) gebildet ist, dessen einer Eingang mit der Notlampe (30) und über einen Widerstand (90) mit einem im wesentlichen festen und von dem an der Notlampe (3) liegenden Potential verschiedenen Potential verbunden ist und dessen anderer Eingang mit einem von der Batterie (1) abgeleiteten vom Anschlußpotential des mit dem ersten Eingang verbundenen Widerstandes (90) gegen das an der Notlampe (30) liegende Potential zu abweichenden Potential verbunden und dessen Ausgang mit einer mit der Anzeige (62) der restlichen Kapazität der Batterie (1) verbundenen Blinkschaltung (56, 68, 91) verbunden ist, die vorzugsweise durch eine Oszillatorschaltung (56, 57, 58) an der ein an seinem Ausgang lediglich ein festes Potential durchschaltender oder dieses trennender Komparator (91) mit seinem einen Eingang über einen Spannungsteiler (59, 60) angeschlossen ist, dessen zweiter Eingang mit über einen mit einem festen Potential (B) und dem Ausgang des Komparators (77) des Fadenbruch-Detektors der Notlampe (30) verbundenen Spannungsteiler (59, 92) verbunden ist, und dessen Ausgang mit den miteinander verbundenen Eingängen der Komparatoren (63) der Einrichtung (62) zur Anzeige der restlichen Kapazität der Batterie (1) verbunden ist, gebildet ist.

7. Gerät nach Anspruch 1, dadurch gekennzeichnet, daß ein Komparator (50) vorgesehen ist, dessen einer Eingang über einen Spannungsteiler (15, 16) an die Batterie (1) angeschlossen ist und dessen Referenzeingang über einen Spannungsteiler (51, 52) an ein über einen Spannungsstabilisator (36, 37) von der Batterie (1) abgeleitetes Potential gelegt ist und dessen Ausgang mit der die den beiden Lampen (29, 30) zugeordneten Schaltern (48, 49) steuernden Logik (43, 47) verbunden ist.

8. Gerät nach Anspruch 1, dadurch gekennzeichnet, daß ein Schalter (51) vorgesehen ist, der in der Stellung "EIN" einen Pufferbetrieb ermöglicht.

9. Gerät nach Anspruch 1, dadurch gekennzeichnet, daß eine Ladebegrenzungsschaltung vorgesehen ist, die durch einen Komparator (17) gebildet ist, dessen Referenzeingang an einen über einen Spannungsregler (6) von einer ungeregelten Gleichspannungsquelle versorgten Spannungsteiler (18, 19) und dessen anderer Eingang über einen Spannungsteiler (15, 16) mit der Batterie (1) verbunden ist und dessen Ausgangssignal eine Ladestrom-Regelschaltung (9, 13) freigibt oder sperrt.

10. Gerät nach Anspruch 9, dadurch gekennzeichnet, daß der Ausgang des Komparators (17) über einen Widerstand (26) und einen Schalter, vorzugsweise eine Diode (27) mit seinem Referenzeingang ( + ) verbunden ist, und damit ein ständiges Nachladen, insbesondere nach Selbstentladung bei längerem Lagern, ermöglicht.

**Claims**

1. Device, in particular a lamp, having a preferably chargeable battery (1), in which an apparatus (62, 63) for indicating the remaining capacity of the battery by means of a multiplicity of LEDs, which apparatus can be connected to the battery by means of a push-button key (61), and in which a comparator and a constant voltage source (36, 37) are provided, which source supplies a reference voltage which lies distinctly below the battery voltage, each LED (62) being connected to the output of a comparator (63) assigned to it and its second electrodes being connected to one another, characterised in that the comparators (63) are each connected by one of their inputs to a potential determined by the battery (1) and their other inputs are fed with different reference voltages, in that the constant voltage source (36, 37) is connected to a series connection of resistors (66 to 76) to which the reference voltages (desired voltages) which are selected according to the characteristic line of the battery (1) used [lacuna], the reference inputs of the comparators (63) being connected to the connecting points of the resistors (66 to 76) and the comparison voltages (actual voltages) being tapped off as a common potential from a voltage divider (64, 65) which can be connected to the battery (1), it being possible to feed said voltages to the other inputs of the comparators (63).

2. Device according to Claim 1 having a load-shedding circuit which disconnects at least a portion of the load in the event of the battery voltage falling below a predetermined value, characterised in that the load-shedding circuit is formed by a comparator (40) which is connected by one input to the constant voltage source (36, 37) via a voltage divider circuit (38, 39), the second input of said comparator being connected to a potential (B/2 +) determined by the battery (1) and, in the event of the battery voltage falling below a predetermined value, said comparator disabling a switch (49), located in series with the lamp (29), preferably via a logic circuit (43, 44, 45, 46, 47) and switching through a switch (48) located in series with an emergency lamp (30), with low power consumption, connected parallel to the lamp (29).

3. Device according to Claim 1 or 2, characterised in that a filament break detector (78, 89) is connected to the point connecting the lamp (29) to the switch (49), which detector, in the event of a filament break of the lamp (29), switches through the switch (48) assigned to the emergency lamp and disables the switch (49) assigned to the lamp (29) and, if appropriate, applies an oscillating signal to the apparatus (62, 63) in order to display the residual capacity.

4. Device according to Claim 2 or 3, characterised in that a filament break detector (77, 90) is connected to the point connecting the emergency lamp (30) to the switch (48) assigned to it and, in the event of a filament break, applies an oscillating signal to the apparatus (62, 63) in order to display the residual capacity.

5. Device according to Claim 4, characterised in that the filament break detector connected to the lamp (29) is formed by a comparator (78), one input of which is connected to the lamp (29) and via a resistor (89) to a potential which is essentially fixed and different from the potential connected to the lamp (29), and the other input of which is connected to a potential which is derived from the battery (1) and is to be differentiated from the terminal potential of the resistor (89) connected to the first input, with respect to the potential connected to the lamp (29), and the output of which is connected to the logic (43, to 47) controlling the switches (48, 49) assigned to the lamps, and, if appropriate, to a flashing circuit (56, 60, 91) connected to the display (62) of the residual capacity of the battery (1), the comparator (78) connecting through preferably only to a fixed potential or disconnecting it.

6. Device according to Claim 5, characterised in that the filament break detector connected to the emergency lamp (30), is formed by a comparator (77), one input of which is connected to the emergency lamp (30) and, via a resistor (90), to an essentially fixed potential which is different from the potential connected to the emergency lamp (30), and the other input of which is connected to a potential which is derived from the battery (1) and is to be differentiated from the terminal potential of the resistor (90) connected to the first input, with respect to the potential connected to the emergency lamp (30), and the output of which is connected to a flashing circuit (56, 68, 91) connected to the display (62) of the residual capacity of the battery (1), which circuit is preferably formed by an oscillator circuit (56, 57, 58) to which a comparator (91) which merely switches through a fixed potential at its output or disconnects said potential is connected by its one input via a voltage divider (59, 60), the second input of which being connected via a voltage divider (59, 92) connected to a fixed potential (B) and to the output of the comparator (77) of the filament break detector of the emergency lamp (30), and the output of which voltage divider being connected to the interconnected inputs of the comparators (63) of the apparatus (62) in order to display the residual capacity of the battery (1).

7. Device according to Claim 1, characterised in that a comparator (50) is provided, one input of which is connected to the battery (1) via a voltage divider (15, 16) and the reference input of which is connected via a voltage divider (51, 52) to a potential derived from the battery (1) via a voltage stabiliser (36, 37), and the output of which is connected to the logic (43, 47) controlling the switches (48, 49) assigned to the two lamps (29, 30).

8. Device according to Claim 1, characterised in that a switch (51) is provided which permits a buffer operation in the "ON" position.

9. Device according to Claim 1, characterised in that a load-limiting circuit is provided which is formed by a comparator (17), the reference input of which is connected to a voltage divider (18, 19) supplied via a voltage controller (6) from an unregulated DC voltage source, and the other input of which is connected via a voltage divider (15, 16) to the battery (1), and the output signal of which enables or disables a charge-current control circuit (9, 13).

10. Device according to Claim 9, characterised in that the output of the comparator (17) is connected via a resistor (26) and a switch, preferably a diode (27), to its reference input (+), and thus constant recharging, in particular after self-discharge during relatively lengthy storage, is made possible.

**Revendications**

1. Appareil, en particulier lampe, avec une batterie (1) de préférence rechargeable, dans lequel un dispositif (62,63) pour afficher la capacité restante de la batterie au moyen d'une pluralité de diodes lumineuses, dispositif susceptible d'être relié à la batterie par l'intermédiaire d'un bouton à touche (61) et dans lequel sont prévus un comparateur et une source de tension constante (36,37) et qui fournit une tension de référence nettement inférieure à la tension de batterie, chaque diode lumineuse (62) étant reliée à la sortie d'un comparateur (63) lui étant associé et dont les deuxièmes électrodes sont reliées entre elles, caractérisé en ce que les comparateurs (63) sont portés par l'une de leurs entrées à un potentiel déterminé par la batterie (1) et leurs autres entrées étant sollicitées par des tensions de référence différentes, que la source de tension constante (36,67) est raccordée à un circuit série de résistances (66 à 76), auxquelles sont raccordées les tensions de référence (tensions de consigne), qui sont sélectionnées suivant la caractéristique de la batterie utilisée (1), les entrées de référence des comparateurs (63) étant raccordées aux points de liaison des résistances (66 à 76) et les tensions de comparaison (tensions réelles) étant prélevées, à titre de potentiel commun, depuis un diviseur de tension (64,65) susceptible d'être relié à la batterie (1), et amenées aux autres sorties des comparateurs (63).

2. Appareil selon la revendication 1, avec un circuit de délestage, qui, lors de la diminution de la tension de batterie au-dessous d'une valeur prédéterminée, désolidarise par commutation au moins une partie de la charge, caractérisé en ce que le circuit de délestage est formé par un comparateur (40), raccordé par une entrée à la source de tension constante, par l'intermédiaire d'un circuit diviseur de tension (38,39), comparateur (40) dont la deuxième entrée est portée à un potentiel $(B/2^+)$ déterminé par la batterie 1, et qui, lors de la diminution de la tension de batterie à une valeur déterminée bloque un interrupteur (49) placé en série avec la lampe (29), de préférence par l'intermédiaire d'un circuit logique (43,44,45,46,47), et rend passant un interrupteur (48) placé en série d'une lampe d'urgence (30) à faible consommation qui est mise en circuit en parallèle par rapport à la lampe (29).

3. Appareil selon la revendication 1 ou 2, caractérisé en ce qu'au point de liaison entre la lampe (29) et l'interrupteur (49) est raccordé un détecteur de rupture de filament (78,89) qui, en cas de rupture de filament d la lampe (29) rend passant l'interrupteur (48) associé à la lampe de secours et bloque l'interrupteur (49) associé à la lampe (29) et, le cas échéant, envoie un signal oscillant au dispositif (62,63) pour indiquer la capacité résiduelle.

4. Appareil selon la revendication 1 ou 2, caractérisé en ce qu'au point de liaison entre la lampe de secours (30) et l'interrupteur (48), qui lui est associé, est raccordé un détecteur de rupture de filament (77,90) qui, en cas de rupture de filament, envoie un signal oscillant au dispositif (62,63) pour indiquer la capacité résiduelle.

5. Appareil selon la revendication 5, caractérisé en ce que le détecteur de rupture de filament raccordé à la lampe (29) est formé par un comparateur (78), dont une entrée est reliée à la lampe (29) et, par l'intermédiaire d'une résistance (89), à un potentiel pratiquement fixe et différent du potentiel appliqué à la lampe (29) et dont l'autre entrée est relié à un potentiel dérivé de la batterie (1), à différencier du potentiel de raccordement de la résistance (89) reliée à la première entrée, par rapport au potentiel appliqué à la lampe (29), et dont la sortie est reliée à la logique qui commande les interrupteurs (48,49) associés aux lampes et, le cas échéant, à un circuit de clignotement (56,60,91) assurant la liaison à l'affichage (62) de la capacité résiduelle de la batterie (1), le comparateur (78) assurant de préférence le passage ou l'isolement seulement à un potentiel fixe.

6. Appareil selon la revendication 5, caractérisé en ce que le détecteur de rupture de filament raccordé à la lampe de secours (30) est formé par un comparateur (77), dont une entrée est relie à la lampe de secours (30) et, par l'intermédiaire d'une résistance (90), à un potentiel qui est différent du potentiel pratiquement fixe et appliqué à la lampe de secours (30), et dont l'autre entrée est reliée à un potentiel dérivé de la batterie, à différencier du potentiel de raccordement de la résistance (90) reliée à la première entrée, par rapport au potentiel appliqué à la lampe de secours (30), et dont la sortie est reliée à un circuit de clignotement (56,68,91) assurant la liaison à l'affichage (62) de la capacité résiduelle de la batterie (1), qui est formé de préférence au moyen d'un circuit oscillateur (56,57,58), auquel est raccordé par l'une de ses entrées, par l'intermédiaire d'un diviseur de tension (59,60), un comparateur (91) qui assure a sa sortie le passage ou l'isolement, seulement d'un potentiel fixe, dont la deuxième entrée est reliée au diviseur de tension (59,92) relié à un potentiel fixe (B) et à la sortie du comparateur (77) du détecteur de rupture de filament de la lampe de secours (30), et dont la sortie est reliée aux entrées, reliées entre elles, des comparateurs (63) du dispositif (62), en vue d'afficher la capacité résiduelle de la batterie.

7. Appareil selon la revendication 1, caractérisé en ce qu'est prévu un comparateur (50) dont une entrée est raccordée à la batterie (1), par l'intermédiaire d'un diviseur de tension (15,16), et dont l'entrée de référence est portée, par l'intermédiaire d'un diviseur de tension (51,52) à un potentiel dérivé de la batterie (1) par l'intermédiaire d'un stabilisateur de tension (36,37) et dont la sortie est reliée à la logique (43,47) qui commande les interrupteurs (48,49) associés aux deux lampes (29,30).

8. Appareil selon la revendication 1, caractérisé en ce qu'est prévu un interrupteur (51) qui permet une fonctionnement tampon lorsqu'il est dans la position "marche".

9. Appareil selon la revendication 1, caractérisé en ce qu'est prévu un circuit limiteur de charge, formé par un comparateur (17), dont l'entrée de référence est reliée à un diviseur de tension (18,19) alimenté par l'intermédiaire d'une régulateur de tension (6) depuis une source de tension continue non régulée, et dont l'autre entrée est reliée, par l'intermédiaire d'un diviseur de tension (15,16) à la batterie (1) et dont le signal de sortie libère ou bloque un circuit de régulation de courant de charge (9,13).

10. Appareil selon la revendication 9, caractérisé en ce que la sortie du comparateur (17) est reliée, par l'intermédiaire d'une résistance (26) et d'un interrupteur, de préférence une diode (27), à son entrée de référence ( + ), et permet ainsi une recharge permanente, en particulier après une autodécharge en cas de stockage prolongé.

Fig.1

220V~

B/2 +

B +

U 6 V 2

+12V

EP 0 207 054 B1

Fig. 2a

Fig. 2b

14

Fig. 2.c